# EUROPEAN PATENT SPECIFICATION

(11) **EP 4 310 929 B1**
(45) Date of publication and mention of the grant of the patent: **16.04.2025**
(21) Application number: 22770957.3
(22) Date of filing: 10.02.2022
(51) Int. Cl.: G06F 3/041, H10N 30/01, H10N 30/098, H10N 30/857, H10N 30/87, H10N 30/88, G02B 1/111, G02B 1/16

(54) **CONDUCTIVE PIEZOELECTRIC MULTI-LAYER FILM AND PRODUCTION METHOD**
LEITFÄHIGER PIEZOELEKTRISCHER MEHRSCHICHTFILM UND HERSTELLUNGSVERFAHREN
FILM MULTICOUCHE PIÉZOÉLECTRIQUE CONDUCTEUR ET PROCÉDÉ DE PRODUCTION

(30) Priority: 19.03.2021 JP 2021046606
(43) Date of publication of application: 24.01.2024
(73) Proprietor: Kureha Corporation, Chuo-ku Tokyo 103-8552 (JP)
(72) Inventor: IMAJI, Makoto, Tokyo 103-8552 (JP); YAMAGUCHI, Kei, Tokyo 103-8552 (JP)
(74) Representative: Novagraaf Group
(86) International application number: PCT/JP2022/005299
(87) International publication number: WO 2022/196198

(56) References cited:
- WO-A1-2015/129829
- JP-A- 2015 186 908
- JP-A- 2015 186 908
- JP-A- 2017 215 319
- JP-A- 2017 216 451
- JP-A- 2019 096 680
- KR-A- 20190 013 777

## Description

### TECHNICAL FIELD

The present invention relates to a conductive piezoelectric multi-layer film and a production method.

### BACKGROUND ART

A touchscreen is widely used as a device capable of inputting information by directly touching an image display unit. Representative forms of this include a capacitive touchscreen using a change in current capacity generated between an electrode and a finger. A conductive film used as a touchscreen is required to be a film that has high transparency and suppressed generation of color.

As such a conductive film, for example, Patent Documents 1 and 2 disclose a conductive film. In the conductive films disclosed in Patent Documents 1 and 2, a polyethylene terephthalate (PET) film is used as a base film, an indium-tin composite oxide (ITO) film is formed as a conductive layer, and the crystallinity of ITO is increased by a heat treatment at around 150°C, thereby achieving a conductive film having high transparency and suppressed generation of color.

### CITATION LIST

### PATENT LITERATURE

Patent Document 1: JP 2017-074792 A
Patent Document 2: JP 2013-25737 A

Further known devices and methods are described by KR 10-2019-0013777 A, JP 2015-186908 A and JP 2017-215319 A. None of these disclosures comprises a sequence of layers as defined by the independent claims.

### SUMMARY OF INVENTION

### TECHNICAL PROBLEM

In recent years, attention has been paid to a technique for simultaneously detecting a position at which an operation surface is touched by a finger or the like and pressing of the operation surface by the finger or the like, and it has been proposed to achieve such a technique by combining a press detection sensor including a piezoelectric sensor. However, the color of the piezoelectric film used for the piezoelectric sensor is impaired when the piezoelectric film is subjected to heat treatment at a high temperature in the same manner as a PET film. Therefore, it is difficult to use, in a touchscreen, a conductive piezoelectric multi-layer film having a piezoelectric film. On the other hand, when an amorphous conductive layer is used without performing a heat treatment, a yellow color derived from the conductive layer is unfortunately generated in the conductive piezoelectric multi-layer film.

An object of one aspect of the present invention is to achieve a film having high transparency and a suitable color in a conductive piezoelectric multi-layer film having a piezoelectric film.

### SOLUTION TO PROBLEM

In order to solve the above problems, a conductive piezoelectric multi-layer film of the present invention includes a first coating layer, a second coating layer, a conductive layer and a piezoelectric film in such a manner that the first coating layer, the second coating layer, and the conductive layer are stacked in this order on at least one surface of the piezoelectric film. The piezoelectric film has a refractive index of 1.30 or greater and 1.50 or less, the first coating layer has a refractive index of 1.45 or greater and less than 1.60, the second coating layer has a refractive index of 1.60 or greater and less than 1.80, and the conductive layer has a refractive index of 1.80 or greater and 2.20 or less.

In order to solve the above problems, the conductive piezoelectric multi-layer film produced by a method for producing a conductive piezoelectric multi-layer film according to one aspect of the present invention is a multi-layer film configured such that a first coating layer, a second coating layer, and a conductive layer are stacked in this order on at least one surface of a piezoelectric film, and the method includes a first step of producing a piezoelectric film where a film having a refractive index of 1.30 or greater and 1.50 or less is formed, a second step of forming a first coating layer having a refractive index of 1.45 or greater and less than 1.60 on at least one surface of the piezoelectric film, a third step of forming a second coating layer having a refractive index of 1.60 or greater and less than 1.80 on a surface of the first coating layer, and a fourth step of forming a conductive layer having a refractive index of 1.80 or greater and 2.20 or less on a surface of the second coating layer.

### ADVANTAGEOUS EFFECTS OF INVENTION

The present invention can achieve a film having high transparency and a suitable color in a conductive piezoelectric multi-layer film having a piezoelectric film.

### BRIEF DESCRIPTION OF THE DRAWINGS

FIG. 1 is a cross-sectional view of a conductive piezoelectric multi-layer film 10 according to one embodiment of the present invention.
FIG. 2 is a cross-sectional view of a modified example 10' of the conductive piezoelectric multi-layer film 10 according to one embodiment of the present invention.

### DESCRIPTION OF EMBODIMENTS

Hereinafter, embodiments of the present invention will be described.

### Configuration of Conductive Piezoelectric Multi-Layer Film

The conductive piezoelectric multi-layer film according to one embodiment of the present invention is configured such that the first coating layer, the second coating layer, and the conductive layer are stacked in this order on at least one surface of a piezoelectric film. The piezoelectric film has a refractive index of 1.30 or greater and 1.50 or less, the first coating layer has a refractive index of 1.45 or greater and less than 1.60, the second coating layer has a refractive index of 1.60 or greater and less than 1.80, and the conductive layer has a refractive index of 1.80 or greater and 2.20 or less.

In the present embodiment, the phrase "stacked in this order" means a state in which the above-described films and layers are arranged in the listed order in a stack including the films and layers. The above-described film and layer may be stacked in contact with each other or may be stacked with another film or layer interposed therebetween, provided that the effects of the present embodiment are achieved.

The conductive piezoelectric multi-layer film according to the present embodiment has, in addition to the above configuration, a configuration in which the refractive index of the first coating layer is higher than the refractive index of the piezoelectric film.

In a more preferred aspect, in addition to the above configuration, the refractive index of the second coating layer is higher than the refractive index of the first coating layer by 0.05 or greater. This configuration more suitably improves transmittance and color.

In the present embodiment, the term "refractive index" refers to a refractive index at a wavelength of 589 nm.

The refractive indices of the first coating layer and the second coating layer are measured in conformity with JIS K7142. Specifically, for each experimentally prepared coating layer, measurement light having a wavelength of 589 nm is incident on each layer and measurement is performed three times at 25.0 ± 1.0°C using an Abbe refractometer, and the average of the measured values is taken as the refractive index.

For the refractive index of the conductive layer, psi (Ψ) and delta (Δ) are measured using a multiple incidence angle fast spectroscopic ellipsometer (M-2000, manufactured by J. A. Woollam Co.Inc.), and the refractive index at a wavelength of 589 nm is calculated therefrom.

The refractive index of the piezoelectric film is measured in conformity with ASTM D542.

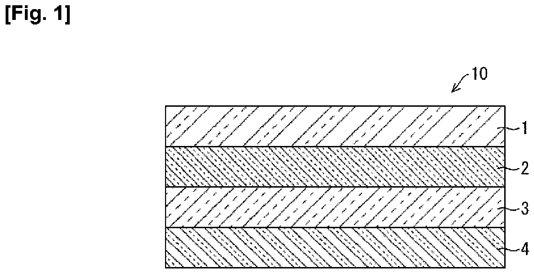

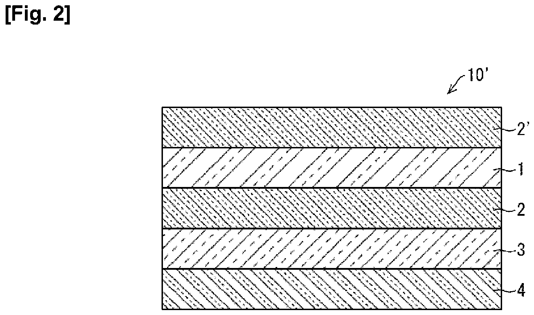

In the present embodiment, as long as the first coating layer, the second coating layer, and the conductive layer are stacked in this order on one surface of the piezoelectric film, the configuration of the other surface of the conductive piezoelectric multi-layer film is not particularly limited. For example, as illustrated in FIG. 1, a first coating layer 2, a second coating layer 3, and a conductive layer 4 may be stacked only on one surface of a piezoelectric film 1 to form the conductive piezoelectric multi-layer film 10. As illustrated in FIG. 2, the first coating layers 2 and 2' may be formed on both surfaces of the piezoelectric film 1, and the second coating layer 3 and the conductive layer 4 may be stacked in this order on the surface of one of the first coating layers 2 to form a conductive piezoelectric multi-layer film 10'. The first coating layer 2, the second coating layer 3, and the conductive layer 4 may be stacked in this order on one surface of the piezoelectric film 1, and the first coating layer 2, the second coating layer 3, and the conductive layer 4 may be stacked in this order also on the other surface.

Hereinafter, as one embodiment of the present invention, the conductive piezoelectric multi-layer film 10 illustrated in FIG. 1 will be mainly described.

### Piezoelectric Film 1

The piezoelectric film 1 included in the conductive piezoelectric multi-layer film 10 according to one embodiment of the present invention means a film having piezoelectricity. For example, the piezoelectric film 1 may be a resin film.

The refractive index of the piezoelectric film 1 is 1.30 or greater and 1.50 or less. The refractive index of the piezoelectric film 1 is preferably 1.35 or greater and 1.47 or less, and more preferably 1.38 or greater and 1.45 or less. The piezoelectric film 1 satisfying such conditions may be produced by a known method, and a raw material and a production method thereof are not particularly limited.

Examples of the resin film satisfying the above conditions include a film made of fluororesin. In the present embodiment, the phrase "made of fluororesin" in the embodiment means that the fluororesin is a main component in a composition constituting the piezoelectric film 1. The clause "fluororesin is a main component" means that the fluororesin is the largest component among the resin components in the composition. A content of the fluororesin in the composition may be 51 mass% or greater, 80 mass% or greater, or 100 mass%.

The resin in the present embodiment may be any resin that can be used for the piezoelectric film 1 of the present invention, and may be one kind of resin or multiple kinds of resins. Examples of the fluororesin that can be used for the piezoelectric film 1 include a vinylidene fluoride resin, a tetrafluoroethylene resin, and a mixture thereof.

Examples of the vinylidene fluoride resin include a homopolymer of vinylidene fluoride and a copolymer thereof. A content of a structural unit derived from a monomer other than vinylidene fluoride in the copolymer of vinylidene fluoride may be appropriately determined within a range where characteristics according to the use of the piezoelectric film 1 can be expressed.

Examples of the monomer other than vinylidene fluoride in the copolymer of vinylidene fluoride include a hydrocarbon monomer and a fluorine compound. Examples of the hydrocarbon monomer include ethylene and propylene. The fluorine compound is a fluorine compound other than vinylidene fluoride, and is a fluorine compound having a polymerizable structure. Examples of the fluorine compound include vinyl fluoride, trifluoroethylene, trifluorochloroethylene, tetrafluoroethylene, hexafluoropropylene, and fluoroalkyl vinyl ether.

For example, the vinylidene fluoride copolymer may be a vinylidene fluoride copolymer (VDF/TFE) produced by copolymerizing vinylidene fluoride and trifluoroethylene at a mixing ratio of 80:20, or a vinylidene fluoride copolymer (VDF/TFE/HFP) produced by copolymerizing vinylidene fluoride, trifluoroethylene, and hexafluoropropene at a mixing ratio of 40:40:20.

Examples of the tetrafluoroethylene resin include a homopolymer of tetrafluoroethylene and a copolymer thereof. Examples of a monomer other than tetrafluoroethylene constituting a structural unit of the copolymer include ethylene, fluoropropylene, fluoroalkyl vinyl ether, perfluoroalkyl vinyl ether, and perfluorodioxole.

A copolymer of vinylidene fluoride and tetratrifluoroethylene can also be suitably used as fluororesin.

The piezoelectric film 1 in the present embodiment may contain various additives within a range where the effect of the present embodiment can be achieved. The additive may be one kind of additive or multiple kinds of additives, and examples thereof include a plasticizer, a lubricant, a crosslinking agent, a UV absorber, a pH controlling agent, a stabilizer, an antioxidant, a surfactant, and a pigment.

A thickness of the piezoelectric film 1 in the present embodiment can be appropriately determined from the range where the effect of the present embodiment can be achieved according to the use of the conductive piezoelectric multi-layer film 10. When the thickness of the piezoelectric film 1 is too thin, the mechanical strength may become insufficient. When the thickness of the piezoelectric film 1 is too thick, on the other hand, the effect peaks out, or the transparency becomes insufficient, and it may become difficult to use the piezoelectric film 1 in optical uses. The thickness of the piezoelectric film 1 can be appropriately determined from a range of 10 µm to 200 µm, for example.

More specifically, from the viewpoint of mechanical strength, the thickness of the piezoelectric film 1 is preferably 10 µm or greater, more preferably 20 µm or greater, and still more preferably 30 µm or greater. From the viewpoint of achievement of both mechanical strength and economic efficiency, the thickness of the piezoelectric film 1 is preferably 200 µm or less, more preferably 150 µm or less, and still more preferably 100 µm or less. The conductive piezoelectric multi-layer film 10 including the piezoelectric film 1 having a thickness within the above range can be suitably used for a touchscreen.

### First Coating Layer 2

The first coating layer 2 in the present embodiment is a layer positioned between the piezoelectric film 1 and the second coating layer 3.

The first coating layer 2 may be disposed only on one surface side of the piezoelectric film 1 as illustrated in FIG. 1, or may be disposed on both sides as illustrated in FIG. 2 from the viewpoint of imparting suitable optical characteristics to the piezoelectric film 1. The first coating layer 2 is preferably disposed adjacent to the piezoelectric film 1 in the thickness direction of the conductive piezoelectric multi-layer film 10 from the viewpoint of increasing the transparency of the conductive piezoelectric multi-layer film 10 and the viewpoint of preventing color development of the piezoelectric film 1 due to the environment.

The refractive index of the first coating layer 2 is 1.45 or greater and less than 1.60. The refractive index of the first coating layer 2 is preferably 1.47 or greater and 1.57 or less, and more preferably 1.49 or greater and 1.55 or less.

A material of the first coating layer 2 may be appropriately selected from any usable materials as long as the material satisfies such a refractive index. The material may be an inorganic material or an organic material, and one or more kinds thereof may be used. Further, the material of the coating layer may be the material of the hard coat layer. Examples of the material include a melamine resin, a urethane resin, a (meth)acrylic acid ester resin, a silane compound, and a metal oxide. The term "(meth)acrylic acid" is a generic term for acrylic acid and methacrylic acid, and means one or both of them. In particular, the (meth)acrylic acid ester resin is preferable from the viewpoints of sufficient transparency, abundance of kinds of material, and low raw material price.

The material of the first coating layer 2 may contain another material necessary for forming the coating layer. As a material of the coating layer made of a (meth)acrylic acid ester resin, a composition formed by mixing an initiator, an oligomer, a monomer, and other components can be generally used. In this case, physical properties of the first coating layer 2 are mainly determined by the oligomer and the monomer. Examples of the oligomer include a monofunctional or a polyfunctional (meth)acrylate. Examples of the monomer include urethane (meth)acrylate, epoxy (meth)acrylate, and polyester (meth)acrylate. Furthermore, from the viewpoints of blocking prevention between films and adhesiveness, inorganic particles, polymer beads, and the like may be added to the material of the first coating layer 2. Usable examples of the inorganic particles include synthetic silica, talc, diatomaceous earth, calcium carbonate, feldspar, quartz, and the like, and in particular, synthetic silica can be preferably used from the viewpoint of achievement of high quality of the plastic film. An example of the synthetic silica includes SiO₂.

The first coating layer 2 may further contain a material for expressing an optional function. For example, the first coating layer 2 may contain an antistatic agent. Examples of the antistatic agent include a surfactant, antimony pentoxide, indium-tin composite oxide (ITO), and conductive polymers.

The thickness of the first coating layer 2 is not particularly limited, but the thickness of the first coating layer 2 may be 0.3 µm or greater and 3.0 µm or less, and more preferably 0.5 µm or greater and 2.0 µm or less.

As in the conductive piezoelectric multi-layer film 10' illustrated in FIG. 2, by coating the first coating layers 2 and 2' on the respective surfaces of the piezoelectric film 1, damages, irregularities, and the like can be prevented on both surfaces of the piezoelectric film 1. Therefore, it is possible to further improve a haze value of the conductive piezoelectric multi-layer film 10'.

The first coating layer 2 may be a transparent surface protective layer for preventing damage, which is also called a hard coat layer.

Furthermore, due to the refractive index and the thickness of the first coating layer 2 falling within the ranges defined above, the haze value of the conductive piezoelectric multi-layer film 10 can be improved.

### Second Coating Layer 3

The second coating layer 3 in the present embodiment is a layer positioned between the first coating layer 2 and the conductive layer 4.

A refractive index of the second coating layer 3 is 1.60 or greater and less than 1.80. The refractive index of the second coating layer 3 is preferably 1.63 or greater and less than 1.78, and more preferably 1.65 or greater and 1.75 or less. It is more preferable that the refractive index of the second coating layer 3 be higher than that of the first coating layer 2 by 0.05 or greater.

A material of the second coating layer 3 may be appropriately selected from any usable materials as long as the material satisfies such a refractive index. For example, a resin having a refractive index adjusted by adding metal oxide fine particles to the material exemplified as the material of the first coating layer 2 may be used. The metal oxide fine particles are preferably a refractive index material having a refractive index of 1.50 or greater. Examples of the metal oxide fine particles include aluminum oxide, titanium oxide, zirconium oxide, zinc oxide, and tin oxide, and among them, titanium oxide and zirconium oxide are preferable.

The material of the second coating layer 3 may contain another material necessary for forming the coating layer, similarly to the material of the first coating layer 2.

A thickness of the second coating layer 3 may be, for example, 50 nm or greater and 500 nm or less. As an example, the film thickness of the second coating layer 3 can be 90 nm or greater and 180 nm or less. As another example, the film thickness of the second coating layer 3 can be 240 nm or greater and 310 nm or less. As still another example, the film thickness of the second coating layer 3 may be 380 nm or greater and 420 nm or less. Due to the thickness of the second coating layer 3 falling within the above range, the transmittance and the color of the conductive piezoelectric multi-layer film 10 can be improved.

The second coating layer 3 has a role of suitably adjusting the transmittance and the color of the conductive piezoelectric multi-layer film 10. In particular, by adjusting the refractive index and the thickness of the second coating layer 3, the conductive piezoelectric multi-layer film 10 having suitable optical characteristics can be achieved.

As described later, when the conductive layer 4 of the present embodiment is amorphous, a color is likely to occur in the conductive piezoelectric multi-layer film 10. In order to suppress the occurrence of such a color, the refractive indices of the first coating layer 2 and the second coating layer 3 are particularly important.

### Conductive Layer 4

The conductive layer 4 in the present embodiment is configured to be stacked on the second coating layer 3.

The conductive layer 4 in the present embodiment has a structure having planar expansion and conductivity, and can also be referred to as an electrode. When the planar spread is assumed to be one layer, the planar spread layer 4 is only required to express sufficient transparency. If such a structure is achieved, the conductive layer 4 itself needs not have transparency. For example, the conductive layer 4 may include a conductive member or composition having high transparency, or may include a material not having transparency, but may have an extremely thin or extremely fine structure capable of expressing sufficient transparency.

The conductive layer 4 may be formed on a transparent substrate and bonded to a transparent coating layer together with the substrate. The conductive layer 4 is only required to be disposed on at least one surface side of the piezoelectric film 1. When the first coating layer 2 is formed on both sides of the piezoelectric film 1, the conductive layer 4 is only required to be disposed on at least any one side of the second coating layers 3. The form of the conductive layer 4 is not limited, and may be a nanowire, a mesh, or a thin film. The thin film may have a single-layer structure or a stacked-layer structure including a plurality of layers.

The material constituting the conductive layer 4 is not limited, and a metal oxide of at least one metal selected from the group consisting of In, Sn, Zn, Ga, Sb, Ti, Si, Zr, Mg, Al, Au, Ag, Cu, Pd, and W is suitably used. The metal oxide may further contain a metal atom selected from the group described above, if necessary. For the metal oxide, ITO, antimony-tin composite oxide (ATO) or the like is preferably used, and ITO is particularly preferably used. Examples of other representative materials for the conductive layer 4 include a silver nanowire, a silver mesh, a copper mesh, graphene, and a carbon nanotube.

A thickness of the conductive layer 4 is not restricted, but is preferably 10 nm or greater from the viewpoint of forming a continuous film having an excellent conductivity of surface resistance value of 1 × 10³ Ω/sq or less. If the thickness becomes too thick, deterioration in transparency may be caused. If the thickness is too thin, electric resistance may become increased, and discontinuous portions may be formed in the film structure. The thickness is preferably 15 nm or greater, more preferably 20 nm or greater, from the viewpoint of further increasing conductivity. From the viewpoint of further increasing a transparency of the conductive layer 4, the thickness of the conductive layer 4 is preferably less than 55 nm, and more preferably less than 45 nm. The thickness of the conductive layer 4 can be determined from observation of a cross section of such a stack and using a known method.

The amorphousness in the conductive layer 4 can be determined using an X-ray diffraction method. The amorphousness can be adjusted depending on presence or absence of implementation and the degree of implementation of a step of promoting crystallization in the preparation of the conductive layer 4, such as annealing after forming the conductive layer 4.

In order to avoid discoloration of the piezoelectric film 1, the conductive piezoelectric multi-layer film 10 in the present embodiment needs to avoid heating at a high temperature in processing. Therefore, the material of the conductive layer 4 may be amorphous. Here, the amorphous refers to a state of a substance in which atoms are irregularly arranged without having a crystal structure. The fact that the conductive layer 4 includes an amorphous material can be confirmed by the fact that a crystal peak of the material of the conductive layer 4 is not detected by the X-ray diffraction method as described above, for example.

The refractive index of the conductive layer 4 of the present embodiment is 1.80 or greater and 2.20 or less. The refractive index of the conductive layer 4 is preferably 1.83 or greater and 2.00 or less, and more preferably 1.85 or greater and 1.95 or less. Due to the refractive index of the conductive layer 4 falling within the above range, problems such as interference fringes can be prevented from occurring and visibility can be suppressed from being reduced.

In one aspect of the conductive piezoelectric multi-layer film 10 of the present embodiment, the conductive layer 4 includes indium-tin composite oxide. In still another aspect, the conductive layer 4 includes indium-tin composite oxide, and is in a state where a peak of the indium-tin composite oxide in X-ray diffraction is not detected. This configuration can provide the conductive layer 4 that is amorphous and has a refractive index within a suitable range.

### Other Layer Configurations

Although not illustrated, the conductive piezoelectric multi-layer film 10 of the present invention is only required to have the piezoelectric film 1, the first coating layer 2, the second coating layer 3, and the conductive layer 4 stacked in this order, and other layer configurations may be appropriately added to provide the conductive piezoelectric multi-layer film of the present invention. The other layer configurations may be one type or more.

For example, one layer of or a plurality of layers of coating layers different from the first coating layer 2 and the second coating layer 3 may be newly included.

When the conductive piezoelectric multi-layer film 10 has a coating layer different from the first coating layer 2 and the second coating layer 3, a total thickness of the coating layers is 0.3 µm to 4.5 µm. In the present embodiment, the "total thickness" of the coating layers is the sum of the thicknesses of the individual coating layers of the conductive piezoelectric multi-layer film 10. When the coating layers are provided only on one principal surface side of the piezoelectric film 1, the total thickness is the thickness of the coating layers on the one principal surface side. When the coating layers are provided on both sides of one principal surface and the other principal surface of the piezoelectric film 1, the total thickness is sum of the thickness of the coating layer(s) on the one principal surface side and the thickness of the coating layer(s) on the other principal surface side.

The conductive piezoelectric multi-layer film 10 may be used in combination with an existing electrode layer. The existing electrode layer plays a role of a sensor for detecting a position, for example. The existing electrode layer may be formed by stacking a conductive layer on a film containing, as a material, any one or more of polyethylene terephthalate (PET), cycloolefin polymer (COP), polycarbonate (PC), and the like. The conductive layer included in the existing electrode layer may include the same material as the conductive layer 4 according to the present invention described above.

Other layer configurations include an adhesive layer and a release layer abutting on the adhesive layer and releasable.

The adhesive layer is a transparent layer having adhesiveness capable of bonding an any layer constituting the conductive piezoelectric multi-layer film 10 or a touchscreen described later to another layer. The adhesive layer is only required to be an adhesive having transparency. Such an adhesive may contain a base polymer expressing transparency and adhesiveness. Examples of the base polymer include an acrylic polymer, a silicone-based polymer, polyester, polyurethane, polyamide, polyvinyl ether, a vinyl acetate/vinyl chloride copolymer, modified polyolefin, an epoxy-based polymer, a fluorine-based polymer, and a rubber-based polymer. Examples of the rubber-based polymer include natural rubber and synthetic rubber. The base polymer can be appropriately selected from the above-mentioned examples. As the adhesive, in particular, an acrylic adhesive is preferably used from the viewpoint of excellent optical transparency, exhibition of adhesive properties such as moderate wettability, cohesiveness, and adhesiveness, and also excellent weather resistance and heat resistance.

Furthermore, a layer for improving the optical characteristics of the conductive piezoelectric multi-layer film 10 may be additionally included as another layer configuration. For example, an anti-glare layer and an anti-reflection layer may be included.

The anti-glare layer is a layer containing fine particles, and has a role of preventing background reflections. For example, the anti-glare layer can be formed by putting fine particles in a resin that becomes a material of the coating layer. The anti-reflection layer is a layer that improves optical characteristics by adjusting the refractive index. The anti-reflection layer can be formed using a resin that becomes a material of the coating layer.

A layer having a protective function may be additionally included. For example, a known antifouling (fingerprint-resistant) layer, a protective film layer, and the like may be included.

A thickness of each layer or the like constituting the conductive piezoelectric multi-layer film 10 can be measured by embedding the conductive piezoelectric multi-layer film 10 in an epoxy resin, cutting the epoxy resin mass so that the cross section of the conductive piezoelectric multi-layer film 10 is exposed, and observing the cross section with a scanning electron microscope. The thickness of the layer may be a representative value for the thickness of the layer, and may be an average value of a plurality of any measured values, a maximum value of the measured values, or a minimum value of the measured values.

### Actions and Effects of Conductive Piezoelectric Multi-Layer Film 10

As described above, the conductive piezoelectric multi-layer film 10 according to the embodiment of the present invention is configured such that the first coating layer 2, the second coating layer 3, and the conductive layer 4 are stacked in this order on at least one surface of the piezoelectric film 1, the refractive index of the piezoelectric film 1 is 1.30 or greater and 1.50 or less, the refractive index of the first coating layer 2 is 1.45 or greater and less than 1.60, the refractive index of the second coating layer 3 is 1.60 or greater and less than 1.80, and the refractive index of the conductive layer 4 is 1.80 or greater and 2.20 or less. With this configuration, the conductive piezoelectric multi-layer film 10 has sufficient piezoelectricity by the piezoelectric film 1, and also has high transparency and a suitable color. In one aspect, the conductive piezoelectric multi-layer film 10 has a configuration in which the layer illustrated on an upper side in FIG. 1 has a lower refractive index and the layer illustrated on a lower side has a higher refractive index. By having such a configuration, the above-described effect becomes more excellent.

The conductive piezoelectric multi-layer film 10 expresses high transparency as described above, and can be suitably used as a press detection sensor of a device such as a touchscreen. Use of the conductive piezoelectric multi-layer film 10 enables a layer configuration of a device such as a touchscreen to be more simplified than ever or to have reduced thickness of a layer as a whole, and enables an increase in a degree of freedom of the number and place of the conductive piezoelectric multi-layer films 10 to be arranged in the device such as a touchscreen.

### Physical Properties of Conductive Piezoelectric Multi-Layer Film 10

The conductive piezoelectric multi-layer film 10 of the present embodiment is preferably sufficiently transparent from the viewpoint of achieving sufficient translucency. In the present embodiment, the term "transparent" may be appropriately determined according to the use of the conductive piezoelectric multi-layer film 10, but means optical characteristics in which visible light is transmitted at a desired ratio or greater, color is suppressed, and turbidity is sufficiently low.

The visible light transmittance of the conductive piezoelectric multi-layer film 10 can be appropriately determined according to the use of the conductive piezoelectric multi-layer film 10. As an example of visible light transmittance, transmittance of light having a wavelength of 550 nm may be measured. A wavelength of 550 nm is a wavelength called maximum photopic sensitivity, and is generally used as a standard for measuring transmittance of visible light. The 550 nm transmittance can be measured, for example, using a haze meter ("NDH7700 SP II", manufactured by Nippon Denshoku Industries Co., Ltd.) according to the method described in JIS K7361-1.

In the present embodiment, the transmittance (hereinafter, referred to as "550 nm transmittance") of the conductive piezoelectric multi-layer film 10 at a wavelength of 550 nm is preferably 83% or greater, and more preferably 85% or greater. When the 550 nm transmittance of the conductive piezoelectric multi-layer film 10 is within the range, the transmittance is sufficiently high for a film used for a device such as a touchscreen.

A degree of suppression of color can be appropriately determined according to the use of the conductive piezoelectric multi-layer film 10. The color may be evaluated by L* value, a* value, and b* value in the L*a*b* color system. Each value in the L*a*b* color system can be measured by a known method described in JIS Z8722 using a spectrocolorimeter, for example.

The conductive piezoelectric multi-layer film 10 of the present embodiment is preferably free from an occurrence of a color from the viewpoint of achieving stable translucency. Since it is preferable to suitably suppress the yellow color derived from the conductive layer 4 in particular, evaluation may be performed with a value of the chromaticity b* value of yellow. Note that the luminosity L* value and the chromaticity a* value of red and green are not particularly limited as long as they do not cause a problem when the conductive piezoelectric multi-layer film 10 is used as a touchscreen.

The conductive piezoelectric multi-layer film 10 of the present embodiment may have b* ≤ 4, and more preferably have b* ≤ 3. The conductive piezoelectric multi-layer film 10 within the range is suppressed in yellow color and has high transparency, and thus can be suitably used for a touchscreen. The b* value is preferably -4 or greater. Furthermore, the L* value of the conductive piezoelectric multi-layer film 10 may be 85 or greater, and the a* value may be 3 or less. The conductive piezoelectric multi-layer film 10 in which each of the L* value, the a* value, and the b* value is within the corresponding range has a sufficiently suppressed color and high transparency for a film used for a device such as a touchscreen.

A degree of turbidity can be appropriately determined according to the use of the conductive piezoelectric multi-layer film 10. The turbidity may be evaluated by a haze value. The haze value can be measured on the basis of the method described in JIS K7136 using a haze meter, for example.

The conductive piezoelectric multi-layer film 10 of the present embodiment has a haze value of preferably 2% or less, more preferably 1.5% or less, and still more preferably 1.0% or less. The conductive piezoelectric multi-layer film 10 having a haze value within the range has sufficiently suppressed turbidity, and can be suitably used in uses of a device such as a touchscreen.

In the conductive piezoelectric multi-layer film 10 of the present embodiment, the surface resistance value and a piezoelectric constant d₃₃ are not particularly limited as long as they are in a range free from a practical problem in uses of a device such as a touchscreen.

The surface resistance value of the conductive piezoelectric multi-layer film 10 can be measured on the basis of a known method described in JIS K7194 using a resistivity meter, for example. The surface resistance value is, for example, preferably 1 × 10³ Ω/sq or less, more preferably 400 Ω/sq or less, more preferably 300 Ω/sq or less, and still more preferably 200 Ω/sq or less. In order to achieve better conductivity in uses of a device such as a touchscreen, the surface resistance value is preferably lower, and examples of the lower limits thereof include 10 Ω/sq or greater and 20 Ω/sq or greater.

The piezoelectric constant d₃₃ of the conductive piezoelectric multi-layer film 10 can be measured using a piezoelectric constant measurement apparatus, for example. For example, this can be done by clipping a sample at 0.2 N, reading the electric charge generated when a force of 0.15 N and 110 Hz is applied, and measuring the absolute value thereof. The piezoelectric constant d₃₃ value is preferably, for example, 6 pC/N or greater, more preferably 10 pC/N or greater, and still more preferably 12 pC/N or greater. The upper limit of the piezoelectric characteristics is not limited, but in the above case, from the viewpoint of sufficiently achieving a desired effect regarding the piezoelectric performance of the piezoelectric film 1, the piezoelectric constant d₃₃ is only required to be 45 pC/N or less, more preferably 35 pC/N or less, and still more preferably 30 pC/N or less.

### Device

A device according to one embodiment of the present invention includes the conductive piezoelectric multi-layer film 10 according to the present embodiment described above. The device may be any device as long as the device includes the conductive piezoelectric multi-layer film 10 in the present embodiment. For example, a position and number of the conductive piezoelectric multi-layer film 10 can be appropriately determined according to the use of the device or the intended function. The conductive piezoelectric multi-layer film 10 may be used in a device as, for example, a press detection sensor such as a touchscreen.

When the conductive piezoelectric multi-layer film 10 is used as a press detection sensor of a touchscreen, the device may have a configuration in which the conductive piezoelectric multi-layer film 10 in the present embodiment is appropriately added to a stacked-layer structure in a known touchscreen of a GFF type, a GF2 type, or the like. In this case, an electrode layer for detecting pressure and a position sensor for detecting a position may be directly stacked on the conductive piezoelectric multi-layer film 10 of the present embodiment, or may be bonded with an adhesive layer interposed therebetween. The touchscreen having such a configuration can further express a function arising from the conductive piezoelectric multi-layer film 10 in addition to the function of a known touchscreen, and it is possible to constitute a touchscreen including both a position sensor and a pressure sensor, for example, in a transparent stacked-layer structure.

When the device is used as a touchscreen, in the production of the touchscreen, the adhesive layer may be formed not only on the coating layer but also on another layer that adheres to the coating layer with the adhesive layer interposed therebetween. In this case, the adhesive layer may be or needs not be provided on the coating layer side.

When the conductive piezoelectric multi-layer film 10 is included in a device, since the conductive piezoelectric multi-layer film 10 has a role of an electrode, it is possible to reduce an electrode layer including, for example, PET/ITO included in a layer structure of a press sensor of a known device. This enables the layer structure of the press detection sensor to be simpler than ever.

### Method for Producing Conductive Piezoelectric Multi-Layer Film 10

Hereinafter, a method for producing the conductive piezoelectric multi-layer film 10 of the present embodiment will be described. The production method according to the present embodiment is a method for producing a multi-layer film configured such that the first coating layer 2, the second coating layer 3, and the conductive layer 4 are stacked in this order on at least one surface of the piezoelectric film 1, and the method includes a first step of producing the piezoelectric film 1 where a film having a refractive index of 1.30 or greater and 1.50 or less is formed, a second step of forming the first coating layer 2 having a refractive index of 1.45 or greater and less than 1.60 on at least one surface of the piezoelectric film 1, a third step of forming the second coating layer 3 having a refractive index of 1.60 or greater and less than 1.80 on a surface of the first coating layer 2, and a fourth step of forming the conductive layer 4 having a refractive index of 1.80 or greater and 2.20 or less on a surface of the second coating layer 3.

The first step is only required to be a step of preparing the piezoelectric film 1, and a step may be appropriately changed or added according to the kind of the piezoelectric film 1 to be prepared. For example, the piezoelectric film 1 can be prepared by continuously performing a step of preparing a resin film by a known method such as a casting method, a hot pressing method, or a melt extrusion method, a step of stretching the resin film, and a step of subjecting a non-polarized resin film to a polarization treatment.

In the second step, the material of the first coating layer 2 is only required to be applied to at least one surface of the piezoelectric film 1 prepared in the first step. The coating method can be a known method, and is not particularly restricted, but a wet coating method is particularly preferable from the viewpoint of productivity and production cost. The wet coating method can be a known method, and typical examples thereof include a roll coating method, a spin coating method, a dip coating method, and a gravure coating method. Among them, a method capable of continuously forming layers, such as the roll coating method and the gravure coating method, is more preferable from the viewpoint of productivity.

For application of the material of the first coating layer 2, for example, a bar coater, a gravure coater, or the like may be used. After application of the material, the material may be dried under a condition of 50°C to 180°C for 0.5 minutes to 60 minutes. Furthermore, the coating film of the first coating layer 2 having been dried may be solidified by UV irradiation. Solidification by UV irradiation can be performed by irradiating UV with an integrated light amount of 50 to 1200 mJ/cm² using a UV irradiation apparatus, for example. Conditions such as an apparatus, a concentration of the material, and a temperature used in the second step may be appropriately changed with reference to the material, the film thickness, and the like of the first coating layer 2.

In the third step, the material of the second coating layer 3 is only required to be applied by a known method to the first coating layer 2 prepared in the second step. For example, similarly to the first coating layer 2, the coating may be performed using a wet coating method. It is also possible to apply the conductive layer 4 in combination by a dry coating method. Conditions such as an apparatus, a concentration of the material, and a temperature in the third step may be the same as those in the second step. The film thickness of the second coating layer 3 can be adjusted by adjusting the concentration of the material.

In the fourth step, the conductive layer 4 is only required to be formed by a known method on the second coating layer 3 prepared in the third step. For formation of the conductive layer 4, the material of the conductive layer 4 is only required to be deposited by a method such as a sputtering method, a vacuum vapor deposition method, or an ion plating method. As these methods, an appropriate method may be employed according to the required film thickness.

When the sputtering method is employed, examples of the target material include the above-mentioned inorganic substances constituting the conductive layer 4, and preferably include ITO. The tin oxide concentration of ITO is, for example, 0.5 mass% or greater, preferably 2 mass% or greater, and, for example, 15 mass% or less, preferably 13 mass% or less.

Examples of a sputtering gas include an inert gas such as Ar. Where necessary, a reactive gas such as an oxygen gas can be used in combination. When the reactive gas is used in combination, the flow rate ratio of the reactive gas is not particularly limited, but is, for example, 0.1 flow rate% or greater and 5 flow rate% or less with respect to a total flow rate ratio of the sputtering gas and the reactive gas.

An atmospheric pressure during sputtering is, for example, 1 Pa or less, preferably 0.7 Pa or less, from the viewpoints of suppression of reduction in a sputtering rate, discharge stability, and the like.

A power source used for the sputtering method may be, for example, a DC power source, an AC power source, a MF power source, an RF power source, or a combination thereof.

The production method of the present embodiment may further include another step as long as it includes the first step to the fourth step. For example, a step of adding another layer configuration to the conductive piezoelectric multi-layer film 10 may be added. A step of subjecting the piezoelectric film 1 to a corona treatment to increase adhesion to the first coating layer 2 may be added.

According to the production method of the present embodiment, it is possible to produce the conductive piezoelectric multi-layer film 10 having high transparency and a suitable color.

In the production method of the present embodiment, the annealing treatment of the conductive layer 4 needs not be performed after the fourth step. By not performing the annealing treatment, the color of the piezoelectric film 1 is not impaired, and therefore it is possible to prepare the conductive piezoelectric multi-layer film 10 that can be suitably used for a device such as a touchscreen.

The present invention is not limited to the above-described embodiments, and various modifications can be made within the scope of the claims, and embodiments obtained by appropriately combining technical means disclosed in different embodiments are also included in the technical scope of the present invention as defined by the claims.

### Recapitulation

The present invention may be embodied as follows.

A conductive piezoelectric multi-layer film according to a present aspect 1 is configured such that a first coating layer, a second coating layer, and a conductive layer are stacked in this order on at least one surface of a piezoelectric film, the piezoelectric film has a refractive index of 1.30 or greater and 1.50 or less, the first coating layer has a refractive index of 1.45 or greater and less than 1.60, the second coating layer has a refractive index of 1.60 or greater and less than 1.80, and the conductive layer has a refractive index of 1.80 or greater and 2.20 or less. This configuration can impart the conductive piezoelectric multi-layer film with high transparency and a suitable color.

A conductive piezoelectric multi-layer film according to a present aspect 2 has b* ≤ 4 in the aspect 1. Since the conductive piezoelectric multi-layer film having this configuration has a suitable color, it can be suitably used for a device such as a touchscreen.

A conductive piezoelectric multi-layer film according to a present aspect 3 has a transmittance of 83% or greater at a wavelength of 550 nm in the aspect 1 or 2. Since the conductive piezoelectric multi-layer film having this configuration has high transparency, it can be suitably used for a device such as a touchscreen.

A conductive piezoelectric multi-layer film according to a present aspect 4 has a haze value of 2.0% or less in any of the aspects 1 to 3. Since the conductive piezoelectric multi-layer film having this configuration has a sufficiently low turbidity, it can be suitably used for a device such as a touchscreen.

In a conductive piezoelectric multi-layer film according to a present aspect 5, in any of the aspect 1 to 4, the conductive layer includes an indium-tin composite oxide, and a peak of the indium-tin composite oxide in X-ray diffraction is not detected. This configuration can provide a conductive layer that is amorphous and has a refractive index within a suitable range.

A device according to a present aspect 6 includes the conductive piezoelectric multi-layer film of any of the present aspects 1 to 5. This configuration can simplify a film structure of a touchscreen or the like in a device more than ever.

A production method according to a present aspect 7 is a method for producing a conductive piezoelectric multi-layer film, the conductive piezoelectric multi-layer film is a multi-layer film configured such that a first coating layer, a second coating layer, and a conductive layer are stacked in this order on at least one surface of a piezoelectric film, and the method includes a first step of producing a piezoelectric film where a film having a refractive index of 1.30 or greater and 1.50 or less is formed, a second step of forming a first coating layer having a refractive index of 1.45 or greater and less than 1.60 on at least one surface of the piezoelectric film, a third step of forming a second coating layer having a refractive index of 1.60 or greater and less than 1.80 on a surface of the first coating layer, and a fourth step of forming a conductive layer having a refractive index of 1.80 or greater and 2.20 or less on a surface of the second coating layer. This configuration can produce a conductive piezoelectric multi-layer film having high transparency and a suitable color.

In a production method according to a present aspect 8, the annealing treatment of the conductive layer is not performed after the fourth step in the aspect 7. Since this configuration does not impair the color of the piezoelectric film, it is possible to prepare a conductive piezoelectric multi-layer film that can be suitably used for a device such as a touchscreen.

### EXAMPLES

### Example 1

A resin film (thickness 120 µm) molded from polyvinylidene fluoride (produced by Kureha Corporation) having an inherent viscosity of 1.3 dL/g was stretched at a stretch ratio of 4.2 times. After stretching, the film was subjected to a polarization treatment by being passed through polarization rolls to produce a piezoelectric film. At that time, the polarization treatment was performed by applying a DC voltage while increasing from 0 kV to 12.0 kV. The film having been subjected to the polarization treatment was further subjected to a heat treatment at 130°C for 1 minute, thereby producing a piezoelectric film having a refractive index of 1.42 and a thickness of 40 µm.

An amorphous silica-containing ultraviolet curable resin composition including an acrylic resin was applied onto an upper surface (surface A) of the piezoelectric film, dried at 80°C, and then irradiated with ultraviolet rays to form a first coating layer (thickness 0.4 µm, refractive index 1.52). Next, the first coating layer (thickness 0.4 µm, refractive index 1.52) was also formed on a lower surface (surface B) of the piezoelectric film in the same manner. Subsequently, a zirconium oxide particle-containing ultraviolet curable resin composition was applied onto an upper surface (surface A) of the first coating layer, dried at 80°C, and then irradiated with ultraviolet rays to form a second coating layer (thickness 114 nm, refractive index 1.65). This gave a stack including the piezoelectric film, the first coating layer, and the second coating layer.

Next, an ITO film having a refractive index of 1.88 and a thickness of 30 nm as a conductive layer was formed on the second coating layer by a reactive sputtering method under the following conditions using, as a target, a sintered body material containing 97 mass% of indium oxide and 3 mass% of tin oxide. This gave a conductive piezoelectric multi-layer film.

### Example 2

A conductive piezoelectric multi-layer film was produced in the same manner as in Example 1 except that the thickness of the second coating layer was changed to 102 nm.

### Example 3

A conductive piezoelectric multi-layer film was produced in the same manner as in Example 1 except that the thicknesses of the first coating layer A, the first coating layer B, the second coating layer, and the conductive layer were changed to 1.0 µm, 0.9 µm, 110 nm, and 35 nm, respectively.

### Example 4

A conductive piezoelectric multi-layer film was produced in the same manner as in Example 1 except that the thickness of the second coating layer was changed to 84 nm.

### Example 5

A conductive piezoelectric multi-layer film was produced in the same manner as in Example 1 except that the refractive index of the second coating layer was changed to 1.75, and the thicknesses of the first coating layer A, the first coating layer B, the second coating layer, and the conductive layer were changed to 1.0 µm, 0.9 µm, 164 nm, and 35 nm, respectively.

### Example 6

A conductive piezoelectric multi-layer film was produced in the same manner as in Example 1 except that the refractive index of the second coating layer was changed to 1.70, and the thicknesses of the first coating layer A, the first coating layer B, the second coating layer, and the conductive layer were changed to 1.0 µm, 1.0 µm, 105 nm, and 28 nm, respectively.

### Example 7

A conductive piezoelectric multi-layer film was produced in the same manner as in Example 1 except that the refractive index of the first coating layer was changed to 1.49, and the thicknesses of the first coating layer B, the second coating layer, and the conductive layer were changed to 1.0 µm, 100 nm, and 28 nm, respectively.

### Comparative Example 1

A conductive piezoelectric multi-layer film was produced in the same manner as in Example 1 except that the first coating layer and the second coating layer were not formed.

### Comparative Example 2

A conductive piezoelectric multi-layer film was produced in the same manner as in Example 3 except that the second coating layer was not formed.

### Comparative Example 3

A conductive piezoelectric multi-layer film was produced in the same manner as in Example 3 except that the refractive index of the second coating layer was changed to 1.52 and the thickness of the second coating layer was 133 nm.

### Comparative Example 4

A conductive piezoelectric multi-layer film was produced in the same manner as in Example 3 except that the refractive index of the second coating layer was changed to 1.52 and the thickness of the second coating layer was 212 nm.

### Comparative Example 5

A conductive piezoelectric multi-layer film was produced in the same manner as in Example 3 except that a hollow silica-containing ultraviolet curable resin composition having a refractive index of 1.35 was applied onto the second coating layer, dried at 80°C, and then irradiated with ultraviolet rays to form a third coating layer having a thickness of 80 nm.

### Comparative Example 6

A conductive piezoelectric multi-layer film was produced in the same manner as in Example 6 except that the refractive index of the first coating layer was changed to 1.65 and the first coating layer B was not provided.

### Comparative Example 7

A conductive piezoelectric multi-layer film was produced in the same manner as in Example 6 except that the refractive index of the first coating layer was changed to 1.39, the first coating layer B was not provided, and the thickness of the second coating layer was 96.

The configurations of the conductive piezoelectric multi-layer films of Examples 1 to 7 and Comparative Examples 1 to 7 are shown in Table 1.

**[Table 1]**

| | | Example 1 | Example 2 | Example 3 | Example 4 | Example 5 | Example 6 | Example 7 | Comparative Example 1 | Comparative Example 2 | Comparative Example 3 | Comparative Example 4 | Comparative Example 5 | Comparative Example 6 | Comparative Example 7 |
|---|---|---|---|---|---|---|---|---|---|---|---|---|---|---|---|
| Refractive Index | Film | 1.42 | 1.42 | 1.42 | 1.42 | 1.42 | 1.42 | 1.42 | 1.42 | 1.42 | 1.42 | 1.42 | 1.42 | 1.42 | 1.42 |
| | First Coating Layer | 1.52 | 1.52 | 1.52 | 1.52 | 1.52 | 1.52 | 1.49 | - | 1.52 | 1.52 | 1.52 | 1.52 | 1.65 | 1.39 |
| | Second Coating Layer | 1.65 | 1.65 | 1.65 | 1.65 | 1.75 | 1.70 | 1.65 | - | - | 1.52 | 1.52 | 1.65 | 1.70 | 1.70 |
| | Conductive Laver | 1.88 | 1.88 | 1.88 | 1.88 | 1.88 | 1.88 | 1.88 | 1.88 | 1.88 | 1.88 | 1.88 | 1.88 | 1.88 | 1.88 |
| | Third Coating Laver | - | - | - | - | - | - | - | - | - | - | - | 1.35 | - | - |
| Thickness | Film (µm) | 40 | 40 | 40 | 40 | 40 | 40 | 40 | 40 | 40 | 40 | 40 | 40 | 40 | 40 |
| | First Coating Layer A (µm) | 0.4 | 0.4 | 1 | 0.4 | 1.0 | 1.0 | 0.4 | - | 1.0 | 1.0 | 1.0 | 1.0 | 1.0 | 1.0 |
| | First Coating Layer B (µm) | 0.4 | 0.4 | 0.9 | 0.4 | 0.9 | 1.0 | 1.0 | - | 0.9 | 0.9 | 0.9 | 0.9 | - | - |
| | Second Coating Layer (nm) | 114 | 102 | 110 | 84 | 164 | 105 | 100 | - | - | 133 | 212 | 100 | 105 | 96 |
| | Conductive Layer (nm) | 30 | 30 | 35 | 30 | 35 | 28 | 28 | 30 | 35 | 35 | 35 | 35 | 28 | 28 |
| | Third Coating Layer (nm) | - | - | - | - | - | - | - | - | - | - | - | 80 | - | - |

### Evaluation

For the films of Examples 1 to 7 and Comparative Examples 1 to 7, the surface specific resistance value, the piezoelectric constant d₃₃ value, the 550 nm transmittance, the haze value, L*, a*, and b* were measured, and the physical properties and optical characteristics of each film were evaluated.

### Physical Properties Evaluation

### Thickness of Coating Layer

Each of the conductive piezoelectric multi-layer films of Examples 1 to 7 and Comparative Examples 1 to 7 was embedded in an epoxy resin, and the epoxy resin mass was cut so that the cross section of the conductive piezoelectric multi-layer film was exposed. The exposed cross section of the conductive piezoelectric multi-layer film was observed under the conditions of an accelerating voltage of 3.0 kV and a magnification of 50000 times using a scanning electron microscope ("SU3800", manufactured by Hitachi High-Tech Corporation), and the thickness of the coating layer in the conductive piezoelectric multi-layer film was measured.

In the measurement of the thickness of each coating layer, the thickness of two points of each coating layer were measured, and the average value thereof was taken as the thickness of each coating layer. Under the above observation conditions, each interface of coating layers was observed as a substantially smooth line, and in the measurement of the thickness of each coating layer, the distance between the interface lines was measured.

### Thickness of Conductive Layer

The cross section of each of the conductive piezoelectric multi-layer films of Examples 1 to 7 and Comparative Examples 1 to 7 was observed under the conditions of an accelerating voltage of 3.0 kV and a magnification of 50000 times using the scanning electron microscope, and the thickness was measured at two points of each ITO film. The average value of the resultant measured values was calculated and taken as the thickness of the conductive layer.

### Surface Resistance Value

The surface resistance value (Ω/sq, hereinafter simply referred to as "resistance value") of each of the conductive piezoelectric multi-layer films of Examples 1 to 7 and Comparative Examples 1 to 7 was measured in conformity with JIS K7194 using a resistivity meter ("LorestaGP MCP-T610", manufactured by Mitsubishi Chemical Analytech Co., Ltd.). The resistance value was measured three times, and the average value of the three results was determined as a representative value. When the resistance value is 400 Ω/sq or less, it can be determined to have no practical problem in use of a device such as a touchscreen.

### Piezoelectric Constant d₃₃ Value

For the piezoelectric constant d₃₃ of each of the conductive piezoelectric multi-layer films of Examples 1 to 7 and Comparative Examples 1 to 7, a sample was clipped at 0.2 N using a piezoelectric constant measurement apparatus ("Piezo Meter System PM300", manufactured by Piezotest Pte Ltd), and charges generated when a force of 0.15 N and 110 Hz was applied were read. Although the measured value of the piezoelectric constant d₃₃ is a positive value or a negative value depending on whether the front or back of the film is to be measured, the absolute value is described herein. When the piezoelectric constant d₃₃ value is 6 pC/N or greater, it can be determined to have no practical problem in use of a device such as a touchscreen.

### Diffraction Peak Derived from ITO

For each of the conductive piezoelectric multi-layer films of Examples 1 to 7 and Comparative Examples 1 to 7, presence or absence of a diffraction peak derived from ITO in X-ray diffraction of the conductive layer was measured. The presence or absence of the diffraction peak was measured by an in-plane method of the surface of the conductive layer using an X-ray diffraction apparatus (XRD). In the measurement, the range of a diffraction angle (2θ) = 15.0 to 70.0° was scanned at a scanning speed of 1°/min. Details of the measurement conditions are described below.

### Measurement Conditions

Apparatus: SmartLab, manufactured by Rigaku Corporation
X-ray source: Cu-Kα (λ = 1.5418 Å) 40 kV 30 mA
Detector: SC-70
Step width: 0.04°
Scan range: 15.0 to 70.0°
Slit: Incident slit = 0.2 mm
Longitudinal control slit = 10 mm
Receiving slit = 20 mm

A diffraction peak derived from ITO was not measured in any of the conductive piezoelectric multi-layer films of Examples 1 to 7 and Comparative Examples 1 to 7.
Optical Characteristics Evaluation
550 nm Transmittance

The 550 nm transmittance of each of the conductive piezoelectric multi-layer films of Examples and Comparative Examples was measured on the basis of the method described in JIS K7361-1 using a haze meter ("NDH7700SP II", manufactured by Nippon Denshoku Industries Co., Ltd.). When the 550 nm transmittance is 83% or greater, it can be determined that there is no problem in practical use in use of a device such as a touchscreen, it is more preferable when the 550 nm transmittance is 84% or greater, and it is still more preferable when the 550 nm transmittance is 85% or greater.

### Haze Value

The haze value of each of the coating films used in Examples and the piezoelectric films used in Comparative Examples was measured on the basis of the method described in JIS K7136 using a haze meter ("NDH7700SP II", manufactured by Nippon Denshoku Industries Co., Ltd.). When the haze value is 2.0 or less, it can be determined to have no practical problem in use of a device such as a touchscreen. It can be determined that the haze value is preferably 2.0 or less, more preferably 1.5% or less, and still more preferably 1.0% or less.

### L* value, a* value, b* value

The L* value, a* value, and b* value in the L*a*b*color system of each of the conductive piezoelectric multi-layer films of Examples and Comparative Examples were measured by a method in conformity with JIS Z8722 using a spectrocolorimeter ("SE7700", manufactured by Nippon Denshoku Industries Co., Ltd.). When the L* value is 85 or greater, it can be determined to have no practical problem in use of a device such as a touchscreen. When the a* value is 3 or less, it can be determined to have no practical problem in use of a device such as a touchscreen. When the b* value is 4 or less, it can be determined to have no practical problem in use of a device such as a touchscreen. It can be determined that the b* value is more preferably 3 or less.

The results of the above evaluation are shown in Table 2.

**[Table 2]**

| | Physical Properties | | Optical Characteristics | | | | |
|---|---|---|---|---|---|---|---|
| | Resistance (Ω/sq) | d₃₃ (pC/N) | 550 nm Transmittance (%) | Haze Value (%) | L* (-) | a* (-) | b* (-) |
| Example 1 | 148 | 17.0 | 85.5 | 0.7 | 94.4 | -0.7 | 2.9 |
| Example 2 | 148 | 17.0 | 84.7 | 0.6 | 94.1 | -0.5 | 1.7 |
| Example 3 | 122 | 16.3 | 85.5 | 0.5 | 93.7 | -0.7 | 2.6 |
| Example 4 | 147 | 16.3 | 84.5 | 0.7 | 93.9 | -0.3 | 1.5 |
| Example 5 | 123 | 16.2 | 84.9 | 0.5 | 94.1 | -1.1 | 1.4 |
| Example 6 | 166 | 14.1 | 86.5 | 0.3 | 94.4 | -0.9 | 1.0 |
| Example 7 | 161 | 14.0 | 86.6 | 0.4 | 94.3 | -0.6 | 2.6 |
| Comparative Example 1 | 155 | 18.1 | 82.5 | 3.3 | 92.7 | 0.3 | 5.0 |
| Comparative Example 2 | 124 | 16.4 | 82.4 | 0.4 | 93.1 | 0.2 | 4.4 |
| Comparative Example 3 | 123 | 16.3 | 83.5 | 0.4 | 93.2 | -0.1 | 4.4 |
| Comparative Example 4 | 124 | 16.2 | 83.2 | 0.5 | 93.1 | 0.3 | 4.8 |
| Comparative Example 5 | 136 | 16.1 | 79.6 | 0.4 | 91.8 | 2.3 | 8.1 |
| Comparative Example 6 | 195 | 14.7 | 83.8 | 2.0 | 94.1 | -0.3 | 4.9 |
| Comparative Example 7 | 376 | 14.7 | 78.7 | 2.5 | 91.0 | 0.2 | 2.9 |

As shown in Table 2, the conductive piezoelectric multi-layer films of Examples 1 to 7 had physical properties free from practical problems in use of a device such as a touchscreen, and had higher transparency and a suitable color. On the other hand, the conductive piezoelectric multi-layer films of Comparative Examples 1 to 7 had b* > 4, and was a film having yellow color.

### INDUSTRIAL APPLICABILITY

The present invention can be used for a device such as a touchscreen.

### REFERENCE SIGNS LIST

1 Piezoelectric film
2, 2' First coating layer
3 Second coating layer
4 Conductive layer
10, 10' Conductive piezoelectric multi-layer film

## Claims

1. A conductive piezoelectric multi-layer film (10), comprising:
a first coating layer (2);
a second coating layer (3);
a conductive layer (4); and
a piezoelectric film (1),
wherein
the first coating layer (2), the second coating layer (3), and the conductive layer (4) are stacked in this order on at least one surface of the piezoelectric film (1),
the piezoelectric film (1) has a refractive index of 1.30 or greater and 1.50 or less,
the first coating layer (2) has a refractive index of 1.45 or greater and less than 1.60,
the second coating layer (3) has a refractive index of 1.60 or greater and less than 1.80,
the conductive layer (4) has a refractive index of 1.80 or greater and 2.20 or less, and
the refractive index of the first coating layer (2) is higher than the refractive index of the piezoelectric film (1).

2. The conductive piezoelectric multi-layer film (10) according to claim 1. wherein b* ≤ 4.

3. The conductive piezoelectric multi-layer film (10) according to claim 1 or 2. wherein a transmittance at a wavelength of 550 nm is 83% or greater.

4. The conductive piezoelectric multi-layer film (10) according to any one of claims 1 to 3, wherein a haze value is 2.0% or less.

5. The conductive piezoelectric multi-layer film (10) according to any one of claims 1 to 4, wherein
the conductive layer (4) includes an indium-tin composite oxide, and
a peak of the indium-tin composite oxide in X-ray diffraction is not detected.

6. A device comprising the conductive piezoelectric multi-layer film (10) according to any one of claims 1 to 5.

7. A method for producing a conductive piezoelectric multi-layer film (10), the conductive piezoelectric multi-layer film (10) being a multi-layer film configured such that a first coating layer (2), a second coating layer (3), and a conductive laye (4) are stacked in this order on at least one surface of a piezoelectric film (1), and
the method comprising:
a first step of producing the piezoelectric film (1) wherein the piezoelectric film (1) having a refractive index of 1.30 or greater and 1.50 or less is formed,
a second step of forming the first coating layer (2) having a refractive index of 1.45 or greater and less than 1.60 on at least one surface of the piezoelectric film (10),
a third step of forming the second coating layer (3) having a refractive index of 1.60 or greater and less than 1.80 on a surface of the first coating layer (2), and
a fourth step of forming the conductive layer (4) having a refractive index of 1.80 or greater and 2.20 or less on a surface of the second coating layer (3).

8. The method for producing a conductive piezoelectric multi-layer film (10) according to claim 7, wherein annealing treatment of the conductive layer (4) is not performed after the fourth step.

## Patentansprüche

1. Leitfähiger piezoelektrischer Mehrschichtfilm (10), umfassend:
eine erste Beschichtungsschicht (2);
eine zweite Beschichtungsschicht (3);
eine leitfähige Schicht (4); und
einen piezoelektrischen Film (1),
wobei
die erste Beschichtungsschicht (2), die zweite Beschichtungsschicht (3) und die leitfähige Schicht (4) in dieser Reihenfolge auf mindestens einer Oberfläche des piezoelektrischen Films (1) gestapelt sind,
der piezoelektrische Film (1) einen Brechungsindex von 1,30 oder mehr und 1,50 oder weniger aufweist,
die erste Beschichtungsschicht (2) einen Brechungsindex von 1,45 oder mehr und weniger als 1,60 aufweist,
die zweite Beschichtungsschicht (3) einen Brechungsindex von 1,60 oder mehr und weniger als 1,80 aufweist,
die leitfähige Schicht (4) einen Brechungsindex von 1,80 oder mehr und 2,20 oder weniger aufweist, und
der Brechungsindex der ersten Beschichtungsschicht (2) höher ist als der Brechungsindex des piezoelektrischen Films (1).

2. Leitfähiger piezoelektrischer Mehrschichtfilm (10) nach Anspruch 1, wobei b* ≤ 4.

3. Leitfähiger piezoelektrischer Mehrschichtfilm (10) nach Anspruch 1 oder 2, wobei die Durchlässigkeit bei einer Wellenlänge von 550 nm 83 % oder mehr beträgt.

4. Leitfähiger piezoelektrischer Mehrschichtfilm (10) nach einem der Ansprüche 1 bis 3, wobei ein Trübungswert 2,0 % oder weniger beträgt.

5. Leitfähiger piezoelektrischer Mehrschichtfilm (10) nach einem der Ansprüche 1 bis 4, wobei
die leitfähige Schicht (4) ein Indium-Zinn-Mischoxid einschließt und ein Peak des Indium-Zinn-Mischoxids bei der Röntgenbeugung nicht erkannt wird.

6. Vorrichtung, die den leitfähigen piezoelektrischen Mehrschichtfilm (10) nach einem der Ansprüche 1 bis 5 umfasst.

7. Verfahren zum Herstellen eines leitfähigen piezoelektrischen Mehrschichtfilms (10), wobei der leitfähige piezoelektrische Mehrschichtfilm (10) ein Mehrschichtfilm ist, der so konfiguriert ist, dass eine erste Beschichtungsschicht (2), eine zweite Beschichtungsschicht (3) und eine leitfähige Schicht (4) in dieser Reihenfolge auf mindestens einer Oberfläche eines piezoelektrischen Films (1) gestapelt sind, und
das Verfahren umfassend:
einen ersten Schritt zum Herstellen des piezoelektrischen Films (1), wobei der piezoelektrische Film (1) mit einem Brechungsindex von 1,30 oder mehr und 1,50 oder weniger gebildet wird,
einen zweiten Schritt zum Bilden der ersten Beschichtungsschicht (2) mit einem Brechungsindex von 1,45 oder mehr und weniger als 1,60 auf mindestens einer Oberfläche des piezoelektrischen Films (10),
einen dritten Schritt zum Bilden der zweiten Beschichtungsschicht (3) mit einem Brechungsindex von 1,60 oder mehr und weniger als 1,80 auf einer Oberfläche der ersten Beschichtungsschicht (2), und
einen vierten Schritt zum Bilden der leitfähigen Schicht (4) mit einem Brechungsindex von 1,80 oder mehr und 2,20 oder weniger auf einer Oberfläche der zweiten Beschichtungsschicht (3).

8. Verfahren zum Herstellen eines leitfähigen piezoelektrischen Mehrschichtfilms (10) nach Anspruch 7, wobei die Glühbehandlung der leitfähigen Schicht (4) nach dem vierten Schritt nicht mehr durchgeführt wird.

## Revendications

1. Film multicouche piézoélectrique conducteur (10), comprenant :
une première couche de revêtement (2) ;
une seconde couche de revêtement (3) ;
une couche conductrice (4) ; et
un film piézoélectrique (1),
dans lequel
la première couche de revêtement (2), la seconde couche de revêtement (3) et la couche conductrice (4) sont empilées dans cet ordre sur au moins une surface du film piézoélectrique (1),
le film piézoélectrique (1) a un indice de réfraction supérieur ou égal à 1,30 et inférieur ou égal à 1,50,
la première couche de revêtement (2) a un indice de réfraction égal ou supérieur à 1,45 et inférieur à 1,60,
la seconde couche de revêtement (3) a un indice de réfraction supérieur ou égal à 1,60 et inférieur à 1,80,
la couche conductrice (4) a un indice de réfraction supérieur ou égal à 1,80 et inférieur ou égal à 2,20, et
l'indice de réfraction de la première couche de revêtement (2) est supérieur à l'indice de réfraction du film piézoélectrique (1).

2. Film multicouche piézoélectrique conducteur (10) selon la revendication 1, dans lequel b* ≤ 4.

3. Film multicouche piézoélectrique conducteur (10) selon la revendication 1 ou 2, dans lequel une transmittance au niveau d'une longueur d'onde de 550 nm est supérieure ou égale à 83 %.

4. Film multicouche piézoélectrique conducteur (10) selon l'une quelconque des revendications 1 à 3, dans lequel une valeur de trouble est inférieure ou égale à 2,0 %.

5. Film multicouche piézoélectrique conducteur (10) selon l'une quelconque des revendications 1 à 4, dans lequel
la couche conductrice (4) comporte un oxyde composite d'indium-étain, et un pic de l'oxyde composite d'indium-étain dans la diffraction des rayons X n'est pas détecté.

6. Dispositif comprenant le film multicouche piézoélectrique conducteur (10) selon l'une quelconque des revendications 1 à 5.

7. Procédé de production d'un film multicouche piézoélectrique conducteur (10), le film multicouche piézoélectrique conducteur (10) étant un film multicouche conçu de telle sorte qu'une première couche de revêtement (2), une seconde couche de revêtement (3) et une couche conductrice (4) sont empilées dans cet ordre sur au moins une surface d'un film piézoélectrique (1), et
le procédé comprenant :
une première étape consistant à produire le film piézoélectrique (1) dans laquelle le film piézoélectrique (1) ayant un indice de réfraction supérieur ou égal à 1,30 et inférieur ou égal à 1,50 est formé,
une deuxième étape consistant à former la première couche de revêtement (2) ayant un indice de réfraction supérieur ou égal à 1,45 et inférieur à 1,60 sur au moins une surface du film piézoélectrique (10),
une troisième étape consistant à former la seconde couche de revêtement (3) ayant un indice de réfraction supérieur ou égal à 1,60 et inférieur à 1,80 sur une surface de la première couche de revêtement (2), et
une quatrième étape consistant à former la couche conductrice (4) ayant un indice de réfraction supérieur ou égal à 1,80 et inférieur ou égal à 2,20 sur une surface de la seconde couche de revêtement (3).

8. Procédé de production d'un film multicouche piézoélectrique conducteur (10) selon la revendication 7, dans lequel un traitement de recuit de la couche conductrice (4) n'est pas effectué après la quatrième étape.
